# EUROPÄISCHE PATENTSCHRIFT

(11) **EP 1 444 782 B1**
(45) Veröffentlichungstag und Bekanntmachung des Hinweises auf die Patenterteilung: **07.07.2010**
(21) Anmeldenummer: 02802600.3
(22) Anmeldetag: 22.10.2002
(51) Int. Cl.: H03K 17/687

(54) **VORRICHTUNG ZUR ANSTEUERUNG EINER ELEKTRISCHEN LAST UND STEUERGERÄT**
DEVICE FOR CONTROLLING AN ELECTRICAL LOAD AND CONTROL UNIT
DISPOSITIF DE COMMANDE D'UNE CHARGE ELECTRIQUE ET APPAREIL DE COMMANDE

(30) Priorität: 03.11.2001 DE 10154158
(43) Veröffentlichungstag der Anmeldung: 11.08.2004
(73) Patentinhaber: ROBERT BOSCH GMBH, 70442 Stuttgart (DE)
(72) Erfinder: SCHENK, Joachim, 38536 Meinersen-Ohof (DE)
(86) Internationale Anmeldenummer: PCT/DE2002/003976
(87) Internationale Veröffentlichungsnummer: WO 2003/041237

(56) Entgegenhaltungen:
- DE-A- 19 611 522
- US-A- 6 140 821

## Beschreibung

### Stand der Technik

Die Erfindung geht von einer Vorrichtung zur Ansteuerung mindestens einer elektrischen Last und von einem Steuergerät nach der Gattung der unabhängigen Ansprüche aus.

Es ist bereits bekannt, dass in Kraftfahrzeugen Relais eingesetzt werden, die üblicherweise nur von einem einzigen Steuergerät angesteuert werden. Angesteuert werden dabei die Anschlüsse einer Spule des elektromagnetischen Stellgliedes.

So sind in der DE 196 11 522 A1 ein Verfahren und eine Vorrichtung zur Fehlererkennung bei einer Endstufenschaltungsanordnung offenbart, wobei wenigstens ein Verbraucher mittels eines ersten·Schaltmittels mit einer Versorgungsspannung und mittels eines zweiten Schaltmittels mit Masse verbindbar ist. Ein Verbindungspunkt zwischen dem ersten Schaltmittel und dem Verbraucher wird über einen Spannungsteiler mit einem vorgebbaren Potential beaufschlagt. Die am Verbindungspunkt anliegende Spannung wird dann zur Fehlererkennung ausgewertet.

### Vorteile der Erfindung

Die erfindungsgemäße Vorrichtung zur Ansteuerung mindestens einer elektrischen Last gemäß des unabhängigen Anspruchs bietet dadurch, dass ein Betriebsmodus vorgesehen ist, in dem eines von zwei Steuergeräten ein Signal in Form mindestens eines Schaltzustandes eines von zwei gesteuerten Schaltern über die Last zum Last-Anschluss des jeweils anderen gesteuerten Schalters sendet und das andere Steuergerät durch seine Erkennungsschaltung den Schaltzustand aus der resultierenden Spannung am Last-Anschluss des anderen gesteuerten Schalters detektiert, den Vorteil, dass gegenüber dem Stand der Technik nur genau ein Last-Anschluss durch einen gesteuerten Schalter ansteuerbar ist und über den gesteuerten Schalter mit genau einem Potenzial, insbesondere einem Betriebsspannungspotenzial oder einem Bezugsspannungspotenzial, verbindbar ist. Auf diese Weise werden zum Betrieb der elektrischen Last zwei gesteuerte Schalter benötigt, um einen der beiden Last-Anschlüssc mit dem Betriebsspannungspotenzial und den anderen der beiden Last-Anschlüsse mit dem Bezugsspannungspotenzial zu verbinden und damit einen Stromfluß in der Last zu ermöglichen. Ist einer der beiden gesteuerten Schalter derart fehlerhaft, dass er immer leitet, so kann die Ansteuerung des elektromagnetischen Stellgliedes immer noch durch den anderen gesteuerten Schalter erfolgen. Auf diese Weise kann die Schaltfunktion des elektromagnetischen Stellgliedes besser und sicherer gewährleistet werden. Auch ist bei Verwendung von zwei gesteuerten Schaltern eine differenziertere Ansteuerung der Last, beispielsweise in Abhängigkeit mehrerer Bedingungen möglich. Besonders vorteilhaft ist es, dass an mindestens einem der beiden Last-Anschlüsse eine Erkennungsschaltung angeschlossen ist, die das Potenzial an diesem Last-Anschluss detektiert. Auf diese Weise läßt sich an diesem Last-Anschluss der Schaltzustand des den anderen Last-Anschluss ansteuernden gesteuerten Schalters ermitteln. Weiterhin kann die Funktionalität der Last erhöht werden, so dass sie nicht nur zum Einleiten eines Lastzustandes der elektrischen Last führt, sondern auch eine Kommunikation zwischen den die Last-Anschlüsse ansteuernden Steuergeräten ermöglicht. Somit können separate Verbindungsleitungen zwischen den Steuergeräten zur Einrichtung einer Kommunikationsverbindung eingespart werden.

Durch die in den Unteranspruchen aufgeführten Maßnahmen sind vorteilhafte Weiterbildungen und Verbesserungen der Vorrichtung und des Steuergerätes gemäß den unabhängigen Ansprüchen möglich.

Ein weiterer Vorteil besteht darin, dass mindestens einem der beiden Schalter ein hochohmiger Widerstand parallel geschaltet oder beispielsweise mittels eines zugeordneten weiteren gesteuerten Schalters beziehungsweise durch Einschalten eines Schalters in einen hochohmigen, aber noch leitenden Zustand schaltbar ist. Auf diese Weise werden die Last-Anschlüssc auf ein definiertes Potential gelegt.

Besonders vorteilhaft ist es, das in einer Stellgliedbetriebsart der Vorrichtung mindestens einer der hochohmigen Widerstände dem einen der die Last ansteuernden gesteuerten Schalter parallel geschaltet ist, so dass an dem dieser Last zugeordneten Last-Anschluss der Schaltzustand des anderen die Last ansteuernden gesteuerten Schalters detektierbar ist. Aufgrund des mindestens einen parallel geschalteten Widerstandes läßt sich an den Last-Anschlüssen ein definiertes Potential und somit eine sichere Detektion des Schaltzustandes erzielen.

Durch die Detektion des Schaltzustandes des einen gesteuerten Schalters lässt sich am Steuergerät des anderen gesteuerten Schalters ermitteln, ob durch den anderen gesteuerten Schalter ein Stromfluß in der Last und damit bei Ausbildung der Last als Spule eines elektromagnetischen Stellgliedes ein ansprechendes elektromagnetisches Stellglied bewirkt werden kann. In Abhängigkeit dieser Information kann dann der andere gesteuerte Schalter angesteuert werden. Auf diese Weise läßt sich eine differenzierte und intelligente Ansteuerung der Last auf einfache Weise realisieren.

Besonders vorteilhaft ist es, dass in einer Kommunikationsbetriebsart der Vorrichtung eine Kommunikation zwischen den beiden Last-Anschlüssen über die Last durch An- oder Abschalten des jeweiligen hochohmigen Widerstandes am einen Last-Anschluss und Detektion der daraus resultierenden Spannung am jeweils anderen Last-Anschluss erfolgt. Auf diese Weise läßt sich die Kommunikation über die Last unabhängig von den die Last ansteuernden gesteuerten Schaltern und somit unabhängig von einer Aktivierung eines elektromagnetischen Stellgliedes realisieren, wenn die Last als Spule eines solchen ausgebildet ist.

### Zeichnung

Ausführungsbeispiele der Erfindung sind in der Zeichnung dargestellt und in der nachfolgenden Beschreibung näher erläutert. Es zeigen:
Figur 1 ein erstes Ausführungsbeispiel für eine erfindungsgemäße Vorrichtung zur Ansteuerung eines elektromagnetischen Stellgliedes,
Figur 2 ein zweites Ausführungsbeispiel für eine erfindungsgemäße Vorrichtung zur Ansteuerung eines elektromagnetischen Stellgliedes,
Figur 3 eine dritte Ausführungsform für eine erfindungsgemäße Vorrichtung zur Ansteuerung eines elektromagnetischen Stellgliedes und
Figur 4 eine vierte Ausführungsform für eine erfindungsgemäße Vorrichtung zur Ansteuerung von zwei elektromagnetischen Stellgliedern.

### Beschreibung der Ausführungsbeispiele

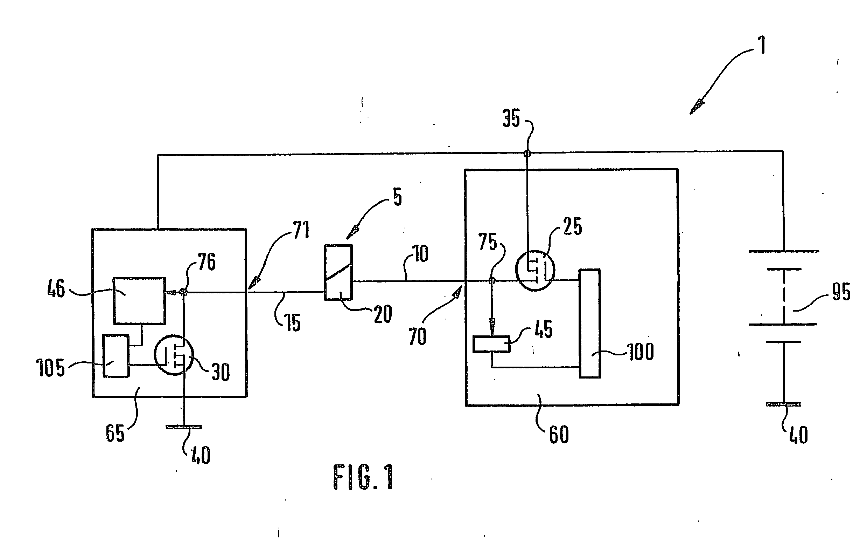

In Figur 1 kennzeichnet 1 eine Vorrichtung zur Ansteuerung eines elektromagnetischen Stellgliedes 5, das in diesem Ausführungsbeispiel beispielhaft als Relais ausgebildet ist und von dem lediglich eine Spule 20 als Beispiel für eine elektrische Last dargestellt ist. Zwischen einem Bezugsspannungspotenzial 40, das im Folgenden als Masse bezeichnet wird, und einem Betriebsspannungspotenzial 35 liegt eine Spannungsquelle 95, beispielsweise eine Batterie eines Kraftfahrzeuges. Die Spannungsquelle 95 dient zur Spannungsversorgung eines ersten Steuergerätes 60 und eines zweiten Steuergerätes 65. Die Spule 20 umfaßt einen ersten Spulenanschluss 10 und einen zweiten Spulenanschluss 15. Der erste Spulenanschluss 10 ist mit einem ersten Anschlußkontakt 75 des ersten Steuergerätes 60 verbunden, wobei der erste Anschlußkontakt 75 den einzigen Anschlußkontakt eines ersten Steueranschlusses 70 des ersten Steuergerätes 60 zur Ansteuerung des Relais 5 bildet. Der zweite Spulenanschluss 15 ist mit einem zweiten Anschlußkontakt 76 des zweiten Steuergerätes 65 verbunden, wobei der zweite Anschlußkontakt 76 den einzigen Anschlußkontakt eines zweiten Steueranschlusses 71 des zweiten Steuergerätes 65 zur Ansteuerung des Relais 5 bildet. Der erste Anschlußkontakt 75 ist einerseits mit einer ersten Erkennungsschaltung 45 des ersten Steuergerätes 60 verbunden. Der erste Anschlußkontakt 75 ist andererseits über einen ersten gesteuerten Schalter 25 des ersten Steuergerätes 60 mit dem Betriebsspannungspotenzial 35 verbindbar. Der zweite Anschlußkontakt 76 ist einerseits mit einer zweiten Erkennungsschaltung 46 des zweiten Steuergerätes 65 verbunden und der zweite Anschlußkontakt 76 ist andererseits über einen zweiten gesteuerten Schalter 30 des zweiten Steuergerätes 65 mit Masse verbindbar. Das erste Steuergerät 60 umfaßt weiterhin eine erste Steuerung 100, an die die erste Erkennungsschaltung 45 angeschlossen ist und die den ersten gesteuerten Schalter 25 ansteuert.

Das zweite Steuergerät 65 umfaßt eine zweite Steuerung 105, an die die zweite Erkennungsschaltung 46 angeschlossen ist und die den zweiten gesteuerten Schalter 30 ansteuert. Die beiden gesteuerten Schalter 25, 30 sind gemäß Figur 1 beispielhaft als Feldeffektransistoren ausgebildet. Einer der beiden gesteuerten Schalter 25, 30 oder beide gesteuerte Schalter 25, 30 können aber auch auf jede andere dem Fachmann bekannte Art und Weise ausgebildet sein, beispielsweise als Bipolartransistor.

In einer Stellgliedbetriebsart bzw. einer Relaisbetriebsart dienen die beiden gesteuerten Schalter 25, 30 zur Ansteuerung der Spule 20 des Relais 5. Sobald beide gesteuerten Schalter 25, 30 geschlossen werden, d. h. in den leitfähigen Zustand versetzt werden, setzt ein Stromfluß durch die Spule 20 des Relais 5 ein und das Relais 5 wird geschaltet Sobald einer der beiden gesteuerten Schalter 25, 30 geöffnet wird, d. h. in den sperrenden Zustand versetzt wird, wird der Stromfluss durch die Spule 20 des Relais 5 unterbrochen und das Relais 5 zurückgeschaltet.

Auf diese Weise kann das Schalten des Relais 5 von zwei Bedingungen abhängig gemacht werden, bei deren Erfüllung sowohl die erste Steuerung 100 den ersten gesteuerten Schalter 25 in den leitenden Zustand als auch die zweite Steuerung 105 den zweiten gesteuerten Schalter 30 in den leitenden Zustand versetzt. Ist nur eine der beiden Bedingungen nicht erfüllt, so wird einer der beiden gesteuerten Schalter 25, 30 derart angesteuert, dass er sperrt, so dass das Relais 5 nicht geschaltet werden kann und in zurückgeschaltetem Zustand vorliegt. Wird durch das Schalten des Relais 5 eine Last in einen Laststromkreis geschaltet, so kann dies also von der gleichzeitigen Erfüllung der beiden Bedingungen abhängig gemacht werden.

Weiterhin kann durch die Verwendung der beiden gesteuerten Schalter 25, 30 eine Sicherungsfunktion realisiert werden. Ist einer der beiden gesteuerten Schalter 25, 30 defekt, indem er unabhängig von seiner Ansteuerung ständig in leitendem Zustand verharrt, so kann das Relais 5 nur noch durch den anderen nicht defekten gesteuerten Schalter geschaltet und zurückgeschaltet werden.

Wird der Schaltzustand des ersten gesteuerten Schalters 25 geändert, so führt dies zu einer Änderung des Potenzials am zweiten Anschlusskontakt 76, die von der zweiten Erkennungsschaltung 46 detektiert wird. Die zweite Erkennungsschaltung 46 kann somit eine Änderung des Schaltzustandes des ersten gesteuerten Schalters 25 detektieren. Sind beispielsweise der erste gesteuerte Schalter 25 und der zweite gesteuerte Schalter 30 zunächst geöffnet und wird dann der erste gesteuerte Schalter 25 geschlossen, so wird das Potenzial am zweiten Anschlußkontakt 76 von einem zunächst undefinierten Wert auf etwa das Betriebsspannungspotenzial 35 gesetzt. Ist das zunächst undefinierte Potenzial ungleich dem Betriebsspannungspotenzial 35, so findet am zweiten Anschlußkontakt 76 bei Schließen des ersten gesteuerten Schalters 25 eine Potenzialänderung auf etwa das Betriebsspannungspotenzial 35 statt, die von der zweiten Erkennungsschaltung 46 detektiert wird. Somit wird von der zweiten Erkennungsschaltung 46 eine Änderung des Schaltzustandes des ersten gesteuerten Schalters 25 detektiert.

Wird umgekehrt bei gleicher Ausgangslage, d. h. bei geöffnetem ersten gesteuerten Schalter 25 und geöffnetem zweiten gesteuerten Schalter 30 der zweite gesteuerte Schalter 30 geschlossen, so ändert sich das Potenzial am ersten Anschlußkontakt 75 von einem undefinierten Potenzial auf etwa die Masse 40, vorausgesetzt das undefinierte Potenzial war ungleich der Masse 40. Auf diese Weise kann in der ersten Erkennungsschaltung 45 diese Potenzialänderung detektiert und ein Schaltvorgang des zweiten gesteuerten Schalters 30 erkannt werden.

Die beschriebene Detektion von Schaltvorgängen des ersten gesteuerten Schalters 25 und des zweiten gesteuerten Schalters 30 kann auch zu einer Kommunikation zwischen den beiden Steuergeräten 60, 65 genutzt werden. Diese Kommunikation kann unabhängig von einer Aktivierung des Relais 5 erfolgen, wenn gewährleistet ist, dass für die Zeitdauer der Kommunikation immer mindestens einer der beiden gesteuerten Schalter 25, 30 geöffnet ist. So kann das erste Steuergerät 60 durch Schalten beziehungsweise Verändern des Schaltzustandes des ersten gesteuerten Schalters 25 ein binäres Signal erzeugen, das durch Detektion des jeweiligen Schaltzustandes am zweiten Anschlusskontakt 76 durch die zweite Erkennungsschaltung 46 im zweiten Steuergerät 65 erkannt werden kann. Während das erste Steuergerät 60 auf diese Weise ein Signal an das zweite Steuergerät 65 über die Spule 20 versendet, ist der zweite gesteuerte Schalter 30 geöffnet. Die Schaltzustände des ersten gesteuerten Schalters 25 werden am zweiten Anschlußkontakt 76 in der beschriebenen Weise durch Detektion des Potenzials bzw. des Spannungspegels am zweiten Anschlußkontakt 76 durchgeführt, der sich aufgrund des jeweiligen Schaltzustandes des ersten gesteuerten Schalters 25 ergibt.

Umgekehrt kann in entsprechender Weise das zweite Steuergerät 65 Signale an das erste Steuergerät 60 über die Spule 20 versenden, indem der Schaltzustand des zweiten gesteuerten Schalters 30 zur Erzeugung eines binären Signals verändert wird und indem am ersten Anschlusskontakt 75 die daraus resultierenden Spannungspegel bzw. -potenziale durch die erste Erkennungsschaltung 45 ermittelt und ausgewertet werden. Dabei ist der erste gesteuerte Schalter 25 offen. Auf diese Weise lässt sich eine bidirektionale Kommunikation zwischen dem ersten Steuergerät 60 und dem zweiten Steuergerät 65 einrichten, wobei aber immer nur eines der beiden Steuergeräte 60, 65 zu einer Zeit senden kann, während das andere der beiden Steuergeräte 60, 65 in dieser Zeit lediglich empfangen kann. Die Binarität des jeweils gesendeten Signals ergibt sich aus dem definierten Potenzial bei Schließen des gesteuerten Schalters des sendenden Steuergerätes und andererseits ein von diesem definierten Potenzial verschiedenes undefiniertes Potenzial bei Öffnen des gesteuerten Schalters des sendenden Steuergerätes. Das vom definierten Potenzial verschiedene undefinierte Potenzial wird dabei wie ein einziger Wert betrachtet, auch wenn verschiedene undefinierte Potenziale bei Öffnen des gesteuerten Schalters des sendenden Steuergerätes auftreten können.

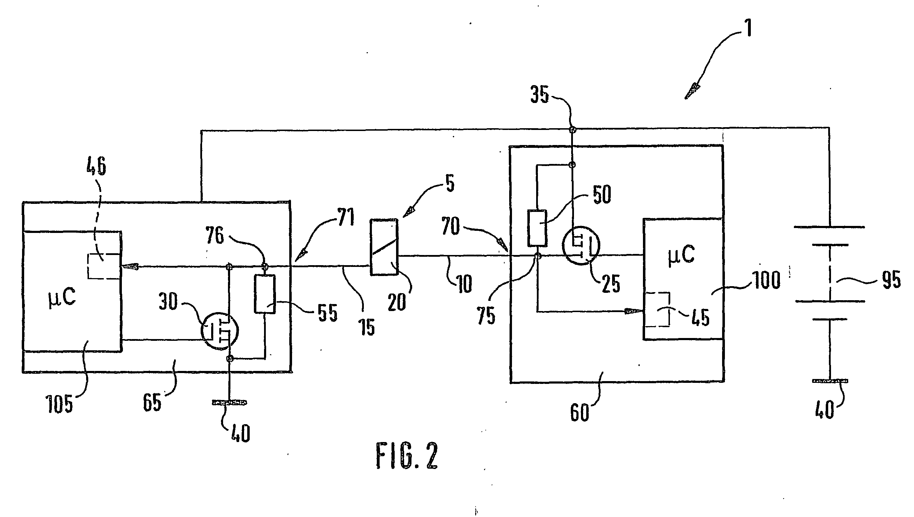

In Figur 2 ist ein zweites Ausführungsbeispiel für die erfindungsgemäße Vorrichtung zur Ansteuerung des Relais dargestellt. Dabei kennzeichnen gleiche Bezugszeichen gleiche Elemente wie in Figur 1. Im Unterschied zu Figur 1 ist dabei die erste Erkennungsschaltung 45 in der ersten Steuerung 100 und die zweite Erkennungsschaltung 46 in der zweiten Steuerung 105 integriert. Ein weiterer Unterschied besteht darin, dass der Schaltstrecke des ersten gesteuerten Schalters 25 nun ein erster hochohmiger Widerstand 50 und der Schaltstrecke des zweiten gesteuerten Schalters 30 ein zweiter hochohmiger Widerstand 55 parallel geschaltet ist. Der erste Widerstand 50 und der zweite Widerstand 55 sind dabei derart hochohmig zu wählen, dass bei geöffnetem ersten gesteuerten Schalter 25 und geöffnetem zweiten gesteuerten Schalter 30 im Wesentlichen kein Strom durch die Spule 20 und somit keine Aktivierung-des Relais 5 erfolgt.

Durch die Verwendung des ersten Widerstandes 50 und des zweiten Widerstandes 55 wird der Vorteil bewirkt, daß am ersten Anschlusskontakt 75 und am zweiten Anschlusskontakt 76 immer ein definiertes Potenzial durch die erste Erkennungsschaltung 45 bzw. die zweite Erkennungsschaltung 46 detektiert werden kann, auch wenn beide gesteuerten Schalter 25, 30 geöffnet sein sollten. Wenn die beiden Widerstände 50, 55 beispielhaft etwa den selben Widerstandswert aufweisen, so beträgt das Potenzial am ersten Anschlusskontakt 75 und am zweiten Anschlusskontakt 76 etwa die Hälfte des Betriebsspannungspotenzials 35, wenn beide gesteuerten Schalter 25, 30 geöffnet sind. Ist der erste gesteuerte Schalter 25 geöffnet und der zweite gesteuerte Schalter 30 geschlossen, so ergibt sich am ersten Anschlusskontakt 75 und am zweiten Anschlusskontakt 76 ein Potenzial, das etwa der Masse 40 entspricht. Ist der zweite gesteuerte Schalter 30 geöffnet und der erste gesteuerte Schalter 25 geschlossen, so ergibt sich am ersten Anschlusskontakt 75 und am zweiten Anschlusskontakt 76 ein Potenzial, das etwa dem Betriebsspannungspotenzial 35 entspricht.

Die Funktionsweise des Ausführungsbeispiels nach Figur 2 ist somit gleich der Funktionsweise des Ausführungsbeispiels nach Figur 1 mit dem Unterschied, daß für den Fall, daß die beiden gesteuerten Schalter 25, 30 geöffnet sind, ein definiertes Potenzial am ersten Anschlusskontakt 75 und am zweiten Anscblusskontakt 76 von der ersten Erkennungsschaltung 45 bzw. von der zweiten Erkennungsschaltung 46 beim zweiten Ausführungsbeispiel nach Figur 2 ermittelt wird und somit kein undefiniertes Potenzial mehr vorliegt. Dabei unterscheidet sich bei geeigneter Wahl der beiden Widerstände 50, 55 dieses Potenzial auch deutlich vom Betriebsspannungspotenzial 35 und von der Masse 40.

Voraussetzung ist, dass nicht der eine der beiden Widerstände 50, 55 erheblich größer als der andere der beiden Widerstände 50, 55 gewählt wird. Ansonsten liegt dieses Potenzial entweder erheblich näher an der Masse 40 als am Betriebsspannungspotenzial 35 oder erheblich näher am Betriebsspannungspotenzial 35 als an Masse 40, wie anhand des Spannungsteilerprinzips leicht nachvollziehbar ist.

Die Einstellung eines definierten Potenzials am ersten Anschlusskontakt 75 und am zweiten Anschlusskontakt 76 bei geöffnetem ersten gesteuerten Schalter 25 und geöffnetem zweiten gesteuerten Schalter 30 ist auch möglich, wenn nur einer der beiden gesteuerten Schalter 25, 30 durch einen Widerstand in seiner Schaltstrecke überbrückt wird, wobei dieser Widerstand wiederum derart hochohmig sein sollte, dass nur dann ein nennenswerter Strom durch die Spule 20 fließen kann, wenn beide gesteuerten Schalter 25, 30 geschlossen sind.

Wird nur die Schaltstrecke eines der beiden gesteuerten Schalter 25, 30 durch einen Widerstand parallel geschaltet, so ist nur eine unidirektionale Kommunikation möglich, wie am folgenden Beispiel verdeutlicht wird. In diesem Beispiel soll die Schaltstrecke des ersten gesteuerten Schalters 25 durch den ersten Widerstand 50 parallel geschaltet sein, wo hingegen die Schaltstrecke des zweiten gesteuerten Schalters 30 keine Parallelschaltung aufweist. In diesem Fall ist nur eine Übertragung von Signalen vom zweiten Steuergerät 65 zum ersten Steuergerät 60 möglich. Soll diese Kommunikation unabhängig von einer Aktivierung des Relais 5 sein, so muss dabei der erste gesteuerte Schalter 25 geöffnet bleiben. Wird dann der zweite gesteuerte Schalter 30 geschlossen, so wird am ersten Anschlusskontakt 75 ein Potenzial durch die erste Erkennungsschaltung 45 detektiert, das etwa der Masse 40 entspricht. Ist der zweite gesteuerte Schalter 30 geöffnet, so ist das am ersten Anschlusskontakt 75 durch die erste Erkennungsschaltung 45 detektierte Potenzial etwa gleich dem Betriebsspannungspotenzial 35.

Bleibt umgekehrt der zweite gesteuerte Schalter 30 ständig geöffnet und wird der erste gesteuerte Schalter 25 abwechselnd geöffnet oder geschlossen, so bleibt das am zweiten Anschlusskontakt 76 durch die zweite Erkennungsschaltung 46 detektierte Potenzial immer etwa gleich dem Betriebsspannungspotenzial 35, so dass vom ersten Steuergerät 60 zum zweiten Steuergerät 65 keine Information über die Spule 20 übertragen werden kann. Die Übertragung von Informationen über die Spule 20 ist somit in diesem Beispiel nur vom zweiten Steuergerät 65 zum ersten Steuergerät 60 möglich. Wenn umgekehrt die Schaltstrecke des zweiten gesteuerten Schalters 30 durch den zweiten Widerstand 55 parallelgeschaltet ist und die Schaltstrecke des ersten gesteuerten Schalters nicht parallelgeschaltet ist, dann ist in entsprechender Weise nur eine unidirektionale Kommunikation bzw. ein Informationsfluss über die Spule 20 vom ersten Steuergerät 60 zum zweiten Steuergerät 65 möglich. Dies ergibt sich aus analogen Betrachtungen des sich jeweils ergebenden Spannungsteilerverhältnisses am ersten Anschlusskontakt 75 bzw. am zweiten Anschlusskontakt 76.

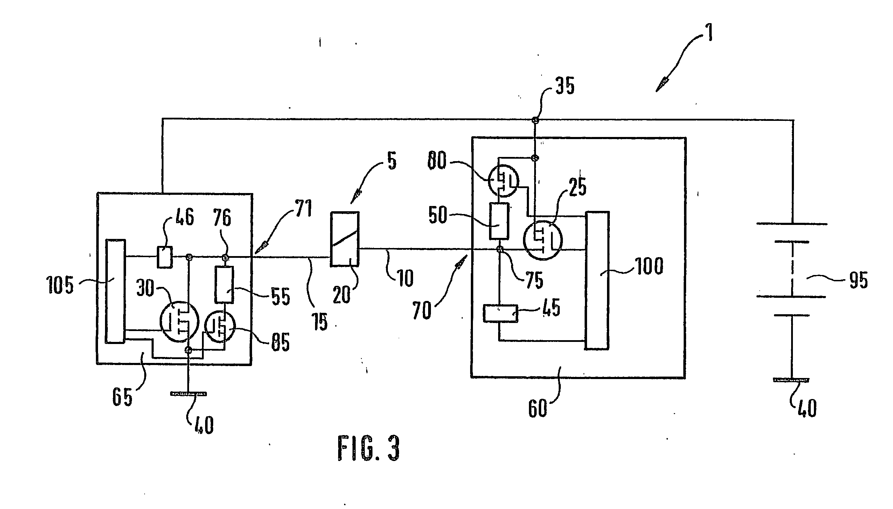

In Figur 3 ist ein drittes Ausführungsbeispiel der erfindungsgemäßen Vorrichtung zur Ansteuerung des Relais 5 dargestellt. Dabei kennzeichnen wiederum gleiche Bezugszeichen gleiche Elemente wie in den vorherigen Figuren. Wie auch im Ausführungsbeispiel nach Figur 1 ist dabei die erste Erkennungsschaltung 45 außerhalb der ersten Steuerung 100 und die zweite Erkennungsschaltung 46 außerhalb der zweiten Steuerung 105 angeordnet. Ansonsten ist gemäß Figur 3 der Schaltstrecke des ersten gesteuerten Schalters 25 eine Serienschaltung aus dem ersten Widerstand 50 und einem dritten gesteuerten Schalter 80 parallelgeschaltet, wobei der dritte gesteuerte Schalter 80 ebenfalls von der ersten Steuerung 100 angesteuert ist. Die Schaltstrecke des zweiten gesteuerten Schalters 30 ist entsprechend durch eine Serienschaltung aus dem zweiten Widerstand 55 und einem vierten gesteuerten Schalter 85 parallelgeschaltet, wobei der vierte gesteuerte Schalter 85 durch die zweite Steuerung 105 angesteuert ist. Ansonsten ist die Schaltung gemäß Figur 3 wie in Figur 1 dargestellt und beschrieben aufgebaut. Der erste Widerstand 50 und der zweite Widerstand 55 beziehungsweise der dritte gesteuerte Schalter 80 und der vierte gesteuerte Schalter 85 sind dabei entsprechend dem zweiten Ausführungsbeispiel derart hochohmig zu wählen, dass ein nennenswerter Stromfluss durch die Spule 20 bei geöffnetem ersten gesteuerten Schalter 25 und geöffnetem zweiten gesteuerten Schalter 30 nicht möglich ist. Der dritte gesteuerte Schalter 80 und der vierte gesteuerte Schalter 85 können ebenfalls wie in dem Beispiel nach Figur 3 dargestellt als Feldeffekttransistor ausgebildet sein oder aber in jeder beliebigen, dem Fachmann bekannten Weise, beispielsweise auch als Bipolartransistor. Werden sowohl der dritte gesteuerte Schalter 80 als auch vierte gesteuerte Schalter 85 gesperrt, so ergibt sich eine Situation, die durch das Schaltbild des ersten Ausführungsbeispieles nach Figur 1 dargestellt ist und in der dort beschriebenen Weise funktioniert. Wird entweder der dritte gesteuerte Schalter 80 oder der vierte gesteuerte Schalter 85 geschlossen, so ergibt sich am ersten Anschlusskontakt 75 und am zweiten Anschlusskontakt 76 bereits ein definiertes Potenzial unabhängig vom Schaltzustand des ersten gesteuerten Schalters 25 und des zweiten gesteuerten Schalters 30, so dass eine gemäß Figur 2 beschriebene Betriebsart realisiert wird, bei der entweder die Schaltstrecke des ersten gesteuerten Schalters 25 oder die Schaltstrecke des zweiten gesteuerten Schalters 30 durch einen Widerstand parallelgeschaltet ist. Ist sowohl der dritte gesteuerte Schalter 80 als auch der vierte gesteuerte Schalter 85 geschlossen, so ergibt sich eine Situation, die der in Figur 2 dargestellten Ausführungsform entspricht und in der dort beschriebenen Weise funktioniert.

Es besteht nun aber zusätzlich eine von der Ansteuerung des Relais 5 durch den ersten gesteuerten Schalter 35 und den zweiten gesteuerten Schalter 30 völlig unabhängigen Möglichkeit der Kommunikation zwischen dem ersten Steuergerät 60 und dem zweiten Steuergerät 65. So kann bei ausgeschaltetem Relaisbetrieb, beispielsweise wenn der erste gesteuerte Schalter 25 und der zweite gesteuerte Schalter 30 beide geöffnet sind eine Kommunikation zwischen den beiden Steuergeräten 60, 65 in der folgenden Weise durchgeführt werden. Wenn das erste Steuergerät 60 ein Signal an das zweite Steuergerät 65 senden will, dann kann der vierte gesteuerte Schalter 85 beispielsweise geschlossen werden. Wird nun der dritte gesteuerte Schalter geöffnet, so detektiert die zweite Erkennungsschaltung 46 am zweiten Anschlusskontakt 76 ein Potenzial, das etwa der Masse 40 entspricht. Wird der dritte gesteuerte Schalter 80 geschlossen, so detektiert die zweite Erkennungsschaltung 46 am zweiten Anschlusskontakt 76 ein Potenzial, das etwa dem halben Betriebsspannungspotenzial 35 entspricht, vorausgesetzt der erste Widerstand 50 und der zweite Widerstand 55 sind etwa gleich groß. Umgekehrt kann beim Senden vom zweiten Steuergerät 65 zum ersten Steuergerät 60 der dritte gesteuerte Schalter 80 geschlossen sein und eine Signalübermittlung über die Spule 20 durch Öffnen und Schließen des vierten gesteuerten Schalters 85 erfolgen, wobei das resultierende Potenzial am ersten Anschlusskontakt 75 durch die erste Erkennungsschaltung 45 ermittelt wird. Auf diese Weise ist ebenfalls eine bi-direktionale Kommunikation zwischen dem ersten Steuergerät 60 und dem zweiten Steuergerät 65 über die Spule 20 möglich, wobei beide Steuergeräte 60, 65 gleichzeitig senden können.

Durch das An- und Abschalten des dritten gesteuerten Schalters 80 beim Sendebetrieb des ersten Steuergerätes 60 wird dann wiederum ein binäres Signal erzeugt mit den beiden Werten Masse 40 und etwa halbes Betriebsspannungspotenzial 35 und beim Sendebetrieb des zweiten Steuergerätes 65 durch Schalten des vierten gesteuerten Schalters 85 wird ein binäres Signal mit den Werten Betriebsspannungspotenzial 35 und etwa halbes Betriebsspannungspotenzial 35 erzeugt.

Alternativ kann es vorgesehen sein, die Schaltstrecke nur des ersten gesteuerten Schalters 25 oder nur des zweiten gesteuerten Schalters 30 durch eine Serienschaltung aus Widerstand und weiterem gesteuerten Schalter parallel zu schalten. Beispielhaft soll dies verdeutlicht werden durch eine Parallelschaltung der Schaltstrecke des zweiten gesteuerten Schalters 30 durch die Serienschaltung aus dem zweiten Widerstand 55 und dem vierten gesteuerten Schalter 85, wo hingegen die Schaltstrecke des ersten gesteuerten Schalters 25 nicht parallelgeschaltet sein soll. Eine bidirektionale Kommunikation lässt sich dann beispielsweise wie folgt realisieren:

Beim Senden vom zweiten Steuergerät 65 zum ersten Steuergerät 60 sollen der erste gesteuerte Schalter 25 und der zweite gesteuerte Schalter 30 geöffnet sein. Wenn der vierte gesteuerte Schalter 85 geöffnet wird, so liegt am ersten Anschlusskontakt 75 ein undefiniertes Potenzial. Wird der vierte gesteuerte Schalter 85 geschlossen, so liegt am ersten Anschlusskontakt 75 als Potenzial etwa die Masse 40. Wenn das undefinierte Potenzial sich von Masse 40 unterscheidet, lässt sich auf diese Weise ein binäres Signal erzeugen und über die Spule 20 vom zweiten Steuergerät 65 zum ersten Steuergerät 60 übertragen.

Umgekehrt soll beim Senden vom ersten Steuergerät 60 zum zweiten Steuergerät 65 der gesteuerte Schalter 85 geschlossen sein, wohingegen der zweite gesteuerte Schalter 30 geöffnet sein soll. Ist nun der erste gesteuerte Schalter 25 geschlossen, so liegt am zweiten Anschlusskontakt 76 etwa das Betriebsspannungspotenzial 35. Ist der erste gesteuerte Schalter 25 hingegen geöffnet, so liegt am zweiten Anschlusskontakt 76 etwa die Masse 40, so dass auch auf diese Weise ein binäres Signal sogar mit definierten Werten erzeugt und vom ersten Steuergerät 60 zum zweiten Steuergerät 65 über die Spule 20 übertragen werden kann.

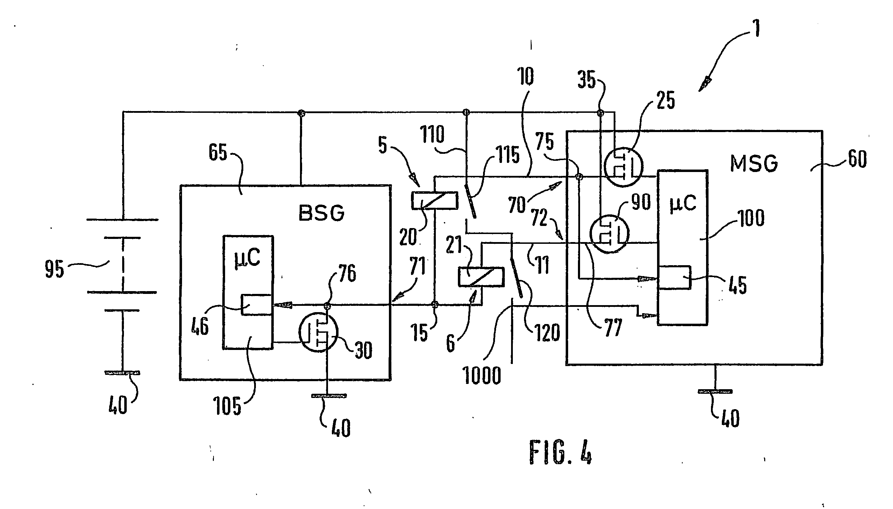

In einem vierten Ausführungsbeispiel nach Figur 4 kennzeichnen gleiche Bezugszeichen gleiche Elemente wie in den vorangegangenen Ausführungsbeispielen. Ausgehend vom ersten Ausführungsbeispiel nach Figur 1 ist dabei die erste Erkennungsschaltung 45 in die erste Steuerung 100 und die zweite Erkennungsschaltung 46 in die zweite Steuerung 105 integriert. Ansonsten ist die Schaltung gemäß dem vierten Ausführungsbeispiel nach Figur 4 gleich aufgebaut wie die Schaltung gemäß dem ersten Ausführungsbeispiel nach Figur 1. Zusätzlich umfasst nun die erste Steuerung 60 einen fünften gesteuerten Schalter 90, der von der ersten Steuerung 100 angesteuert und beispielsweise als Feldeffekttransistor ausgebildet ist. Der fünfte gesteuerte Schalter 90 kann aber auch in jeder anderen beliebigen dem Fachmann geläufigen Weise ausgebildet sein, beispielsweise als Bipolartransistor. Weiterhin ist ein zweiter Relaisanschluss mit einer zweiten Spule 21 vorgesehen, die einen dritten Spulenanschluss 11 und einen vierten Anschluß aufweist, der gemeinsam mit dem ersten Relais 5 und dessen zweiten Spulenanschluss 15 verbunden ist. Der dritte Spulenanschluss 11 ist mit einem dritten Anschlusskontakt 77 verbunden, der als einziger Anschlusskontakt eines dritten Steueranschlusses 72 des ersten Steuergerätes 60 ausgebildet ist. Der dritte Anschlusskontakt 77 ist über den fünften gesteuerten Schalter 90 mit dem Betriebsspannungspotenzial 35 verbindbar. Ansonsten ist die Schaltung gemäß Figur 4 wie in Figur 1 aufgebaut. Auf diese Weise können die beiden Spulen 20, 21 unabhängig voneinander über den ersten gesteuerten Schalter 25 bzw. den fünften gesteuerten Schalter 90 des ersten Steuergerätes 60 mit dem Betriebsspannungspotenzial 35 verbunden werden, wohingegen ihre Verbindung mit der Masse 40 gemeinsam über den zweiten gesteuerten Schalter 30 des zweiten Steuergerätes 65 erfolgt. Die beiden Relais 5, 6 sind somit unabhängig voneinander über die erste Steuerung 100 des ersten Steuergerätes 60 aktivierbar. Wenn nun die beiden Relais 5, 6 wie in Figur 4 dargestellt den gleichen Laststromkreis, der in Figur 4 mit dem Bezugszeichen 110 gekennzeichnet ist, schalten, wobei der Laststromkreis 110 ebenfalls an das Betriebsspannungspotenzial 35 einerseits und andererseits in nicht dargestellter Weise an die Masse 40 angebunden ist, so lassen sich bereits drei verschiedene und voneinander unabhängige Bedingungen für das Schließen des Laststromkreises 110 mittels des ersten gesteuerten Schalters 25, des zweiten gesteuerten Schalters 30 und des fünften gesteuerten Schalters 90 realisieren.

Alternativ kann natürlich auch der masseseitige Anschlusspunkt der zweiten Spule 21 unabhängig vom zweiten Spulenanschluss 15 der ersten Spule 20 über einen zusätzlichen gesteuerten Schalter des zweiten Steuergerätes 65 mit der Masse 40 verbindbar sein, so dass auf diese Weise sogar vier Bedingungen für das Schließen des Laststromkreises 110 mittels der beiden Relais 5, 6 realisierbar sind.

Weiterhin alternativ können natürlich auch die beiden betriebsspannungsseitigen Anschlusspunkte der Spulen 20, 21 über einen gemeinsamen gesteuerten Schalter des ersten Steuergerätes 60 mit dem Betriebsspannungspotenzial 35 verbunden sein.

Weiterhin können auch mehr als zwei Relais in entsprechender Weise durch das erste Steuergerät 60 und das zweite Steuergerät 65 angesteuert werden. Die verschiedenen vom ersten Steuergerät 60 und vom zweiten Steuergerät 65 angesteuerten Relais können dabei Schalter im gleichen Laststromkreis wie in Figur 4 dargestellt oder in verschiedenen Laststromkreisen betätigen. Gemäß Figur 4 betätigt dabei das erste Relais 5 einen ersten Schalter 115 und das zweite Relais 6 einen zweiten Schalter 120.

Vorteilhaft ist diese Reihenschaltung des ersten Schalters 115 und des zweiten Schalters 120 des Laststromkreises 110, wenn ein Relaiskontaktpaar verschmolzen ist und somit eine Trennung durch das zweite Kontaktpaar gewährleistet ist. Wird vorteilhafterweise das Potenzial 1000 an einem der Kontakte des zweiten Schalters 120 wie in Figur 4 vom ersten Steuergerät 60 von einem der Steuergeräte 60, 65 detektiert, so ist zusätzlich eine Diagnose des Laststromkreises 110 durch einzelnes Schalten der Relais 5, 6 möglich.

Durch die bereits im ersten Ausführungsbeispiel beschriebene Möglichkeit der Detektion des Schaltzustandes des gesteuerten Schalters des einen Steuergerätes in der Erkennungsschaltung des anderen Steuergerätes kann im anderen Steuergerät erkannt werden, ob ein Schließen des eigenen gesteuerten Schalters das Relais aktiviert oder nicht.

In der Relaisbetriebsart der Vorrichtung 1 ist es wie beschrieben möglich, im einen Steuergerät den Schaltzustand des gesteuerten Schalters des anderen Steuergerätes zu detektieren. Die Detektion dieses Schaltzustandes erfolgt dabei in gleicher Weise wie in der Kommunikationsbetriebsart gemäß den beschriebenen Ausführungsbeispielen, sofern die Kommunikation durch Ändern des Schaltzustandes des ersten gesteuerten Schalters 25 oder des zweiten gesteuerten Schalters 30 erfolgt. Dabei wird in der Relaisbetriebsart im einen Steuergerät der Schaltzustand des gesteuerten Schalters des anderen Steuergerätes an sich ermittelt, um zu prüfen, ob durch Schließen des eigenen gesteuerten Schalters das Relais aktiviert werden kann, wohingegen im Kommunikationsbetrieb es nicht auf den Schaltzustand an sich ankommt, sondern auf die durch einander abwechselnde Schaltzustände definierte Bitfolge. So können beispielsweise bei den Ausführungsbeispielen nach Figur 2 und Figur 3 eine Relaisbetriebsart der Vorrichtung 1 realisiert werden, bei der mindestens einer der hochohmigen Widerstände 50, 55 dem einen der die Spule 20 ansteuernden gesteuerten Schalter parallel geschaltet ist, so dass an dem dieser Spule 20 zugeordneten Spulenanschluss der Schaltzustand des anderen die Spule 20 ansteuernden gesteuerten Schalters detektierbar ist.

Bei den beschriebenen Beispielen ist die Last 20 als Spule ausgebildet und stellt somit eine induktive Last dar. Selbstverständlich kann die Last 20 auch rein ohmsch ausgebildet sein. Generell kann die Last 20 ohmsch und/oder induktiv ausgebildet sein.

## Patentansprüche

1. Vorrichtung (1) zur Ansteuerung mindestens einer elektrischen Last (20), insbesondere einer Spule eines elektromagnetischen Stellgliedes, mit einem ersten Last-Anschluss (10, 11) und mit einem zweiten Last-Anschluss (15), wobei der erste Last-Anschluss (10, 11) über einen ersten gesteuerten Schalter (25) mit einem Betriebsspannungspotenzial (35) und der zweite Last-Anschluss (15) über einen zweiten gesteuerten Schalter (30) mit einem Bezugsspannungspotenzial (40) unter Verwendung eines ersten, dem ersten Last-Anschluss (10) zugeordneten und eines zweiten, dem zweiten Last-Anschluss (15) zugeordneten Steuergeräts (60, 65) verbindbar ist, und wobei an mindestens einem der beiden Last-Anschlüsse (10, 15) eine Erkennungsschaltung (45, 46) des jeweiligen Steuergeräts (60, 65) angeschlossen ist, die das Potenzial an diesem Last-Anschluss (10, 15) detektiert, **dadurch gekennzeichnet, dass** ein Betriebsmodus vorgesehen ist, in dem eines der beiden Steuergeräte (60, 65) ein Signal in Form mindestens eines Schaltzustandes eines der beiden gesteuerten Schalter (25, 30) über die Last (20) zum Last-Anschluss des anderen gesteuerten Schalters (30, 25) sendet und das andere Steuergerät (65, 60) durch seine Erkennungsschaltung (46, 45) den Schaltzustand aus der resultierenden Spannung am Last-Anschluss des anderen gesteuerten Schalters (3 0, 25) detektiert.

2. Vorrichtung (1) nach Anspruch 1, **dadurch gekennzeichnet, dass** mindestens einem der beiden gesteuerten Schalter (25, 30) ein hochohmiger Widerstand (50, 55) parallel geschaltet oder schaltbar ist.

3. Vorrichtung (1) nach Anspruch 2, **dadurch gekennzeichnet, dass** die Parallelschaltung des jeweiligen hochohmigen Widerstandes (50, 55) durch einen zugeordneten weiteren gesteuerten Schalter (80, 85) erfolgt

4. Vorrichtung (1) nach einem der Ansprüche 2 oder 3, **dadurch gekennzeichnet, dass** in einer Stellgltcdbctriebsart, insbesondere einer Lastbetriebsart, der Vorrichtung (1) mindestens einer der hochohmigen Widerstände (50, 55) dem einen der die Last (20) ansteuernden gesteuerten Schalter (25, 30) parallel geschaltet ist, so dass an dem dieser Last (20) zugeordneten Last-Anschluss (10, 15) der Schaltzustand des anderen die Last (20) ansteuernden gesteuerten Schalters (30, 25) detektierbar ist.

5. Vorrichtung (1) nach einem der Ansprüche 2 bis 4, **dadurch gekennzeichnet, dass** in einer Kommunikationsbetriebsart der Vorrichtung (1) eine Kommunikation zwischen den beiden Last-Anschlüssen (10, 15) über die Last (20) durch An- oder Abschalten des jeweiligen hochohmigen Widerstandes (50, 55) am einen Last-Anschluss (10, 15) und Detektion der daraus resultierenden Spannung am jeweils anderen Last-Anschluss (15, 10) erfolgt.

## Claims

1. Apparatus (1) for controlling at least one electrical load (20), in particular a coil in an electromagnetic actuating element, having a first load connection (10, 11) and having a second load connection (15), wherein the first load connection (10, 11) can be connected via a first controlled switch (25) to an operating voltage potential (35), and the second load connection (15) can be connected via a second controlled switch (30) to a reference voltage potential (40), using a first controller (60) which is associated with the first load connection (10), and a second controller (65) which is associated with the second load connection (15), and wherein an identification circuit (45, 46) for the respective controller (60, 65) is connected to at least one of the two load connections (10, 15) and it detects the potential at this load connection (10, 15), **characterized in that** an operating mode is provided in which one of the two controllers (60, 65) sends a signal in the form of at least one switching state of one of the two controlled switches (25, 30) via the load (20) to the load connection of the other controlled switch (30, 25), and the identification circuit (46, 45) of the other controller (65, 60) detects the switching state from the resultant voltage at the load connection of the other controlled switch (30, 25).

2. Apparatus (1) according to Claim 1, **characterized in that** a high-resistance resistor (50, 55) is or can be connected in parallel with at least one of the two controlled switches (25, 30).

3. Apparatus (1) according to Claim 2, **characterized in that** the respective high-resistance resistor (50, 55) is connected in parallel by an associated further controlled switch (80, 55).

4. Apparatus (1) according to one of Claims 2 or 3, **characterized in that,** in an actuating element operating mode, in particular a load operating mode, of the apparatus (1) at least one of the high-resistance resistors (50, 55) is connected in parallel with one of the controlled switches (25, 30) which control the load (20), such that the switching state of the other control switch (30, 25) which controls the load (20) can be detected at the load connection (10, 15) which is associated with this load (20).

5. Apparatus (1) according to one of Claims 2 to 4, **characterized in that,** in a communication operating mode of the apparatus (1), communication takes place between the two load connections (10, 15) via the load (20) by connecting or disconnecting the respective high-resistance resistor (50, 55) to or from the load connection (10, 15) and by detection of the voltage which results from this at the respective other load connection (15, 10).

## Revendications

1. Dispositif (1) pour la commande d'au moins une charge électrique (20), en particulier la bobine d'un organe électromagnétique de réglage, et présentant
une première borne de charge (10, 11) et une deuxième borne de charge (15),
la première borne de charge (10, 11) pouvant être reliée par un premier commutateur asservi (25) à un potentiel (35) de tension de service et la deuxième borne de charge (15) par un deuxième commutateur asservi (30) à un potentiel (40) de tension de référence par recours à un premier appareil de commande (60) associé à la première borne de charge (10) et à un deuxième appareil de commande (65) associé à la deuxième borne de charge (15),
un circuit de détection (45, 46) de l'appareil de commande (60, 65) respectif étant raccordé à l'une des deux bornes de charge (10, 15) et détectant le potentiel sur cette borne de charge (10, 15), **caractérisé en ce que**
le dispositif présente un mode de fonctionnement dans lequel par l'intermédiaire de la charge (20), l'un des deux appareils de commande (60, 65) envoie à la borne de charge de l'autre commutateur asservi (30, 25) un signal qui présente la forme d'au moins un état de commutation de l'un des deux commutateurs asservis (25, 30) et
**en ce qu'**à partir de la tension résultante sur la borne de charge de l'autre commutateur asservi (30, 25), l'autre appareil de commande (65, 60) détecte l'état de commutation par son circuit de détection (46, 45).

2. Dispositif (1) selon la revendication 1, **caractérisé en ce qu'**une résistance (50, 55) à haute valeur ohmique est raccordée ou peut être raccordée en parallèle à au moins l'un des deux commutateurs asservis (25, 30).

3. Dispositif (1) selon la revendication 2, **caractérisé en ce que** le circuit parallèle des deux résistances (50, 55) à haute valeur ohmique s'effectue par un autre commutateur asservi (80, 85) qui lui est associé.

4. Dispositif (1) selon l'une des revendications 2 ou 3, **caractérisé en ce que** lorsque le dispositif (1) fonctionne en mode d'organe de réglage, en particulier en mode de charge, au moins l'une des résistances (50, 55) à haute valeur ohmique est raccordée en parallèle à l'un des commutateurs asservis (25, 30) qui commande la charge (20), de telle sorte que l'état de commutation de l'autre commutateur asservi (30, 25) qui commande la charge (20) puisse être détecté sur la borne de charge (10, 15) associée à cette charge (20).

5. Dispositif (1) selon l'une des revendications 2 à 4, **caractérisé en ce que** lorsque le dispositif (1) fonctionne en mode de communication, une communication a lieu entre les deux bornes de charge (10, 15) par l'intermédiaire de la charge (20), par branchement ou débranchement de la résistance (50, 55) à haute valeur ohmique concernée sur une borne de charge (10, 15) et détection de la tension résultante sur l'autre borne de charge (15, 10).
